# FASCICULE DE BREVET EUROPEEN

(11) **EP 3 931 584 B1**
(45) Date de publication et mention de la délivrance du brevet: **01.03.2023**
(21) Numéro de dépôt: 20712400.9
(22) Date de dépôt: 31.01.2020
(51) Int. Cl.: G01R 31/392, G01R 31/396, B60L 58/16

(54) **PROCÉDÉ ET SYSTÈME DE DÉTERMINATION DE L'ÉTAT DE SANTÉ D'UNE BATTERIE D'UN VÉHICULE TERRESTRE À MOTEUR**
VERFAHREN UND SYSTEM ZUR BESTIMMUNG DES GESUNDHEITSZUSTANDS EINER BATTERIE EINES MOTORISIERTEN LANDFAHRZEUGS
METHOD AND SYSTEM FOR DETERMINING THE STATE OF HEALTH OF A BATTERY OF A MOTORISED LAND VEHICLE

(30) Priorité: 26.02.2019 FR 1901982
(43) Date de publication de la demande: 05.01.2022
(73) Titulaire: PSA Automobiles SA, 78300 Poissy (FR)
(72) Inventeur: BENANE, Said, 94240 L HAY LES ROSES (FR)
(86) Numéro de dépôt international: PCT/FR2020/050165
(87) Numéro de publication internationale: WO 2020/174139

(56) Documents cités:
- WO-A1-2013/167833
- WO-A1-2015/132544

## Description

### Domaine technique de l'invention

La présente invention concerne le domaine des systèmes pour la maintenance de batteries embarquées à bord de véhicules terrestres à moteur. L'invention porte notamment sur un procédé de détermination d'une valeur d'un paramètre caractérisant l'état de santé d'une batterie formée de plusieurs cellules et embarquée à bord d'un véhicule terrestre à moteur. L'invention porte également sur un système mettant en oeuvre un tel procédé. L'invention s'applique notamment véhicules automobiles.

### Etat de la technique antérieure

Aujourd'hui, la maintenance des véhicules électriques repose principalement sur la vérification de la chaine de traction électrique. Pour ce faire, il est nécessaire d'immobiliser le véhicule pendant une durée moyenne de 48 heures afin d'effectuer une décharge complète puis une charge complète de la batterie. Par conséquent, le processus de vérification du bon fonctionnement d'une batterie d'un véhicule électrique reste très contraignant pour l'utilisateur dans la mesure où il implique une indisponibilité du véhicule pendant une durée relativement longue. Ceci est regrettable dans la mesure où ces contraintes peuvent dissuader d'éventuels futurs acquéreurs de véhicules électriques et ainsi limiter la diffusion des véhicules électriques au sein du parc automobile mondial alors qu'il est notoire que ces véhicules sont les moins polluants.

WO 2015/132544 A1 divulgue une méthode et un système pour estimer l'état de charge d'une batterie comportant plusieurs cellules électrochimiques connectées en série.

### Résumé de l'invention

L'invention vise à fournir un procédé et un système pour pallier ces inconvénients. L'invention vise en particulier à fournir un procédé et un système qui contribuent pour permettre de contrôler le bon fonctionnement d'une batterie embarquée à bord d'un véhicule terrestre à moteur sans pour autant nécessiter l'immobilisation du véhicule. Plus spécifiquement, l'invention a pour but de fournir un procédé et un système qui permettent de déterminer à distance l'état de santé d'une batterie embarquée à bord d'un véhicule terrestre à moteur.

Ces buts sont atteints, selon l'invention, au moyen d'un procédé de détermination d'une valeur d'un paramètre caractérisant l'état de santé d'une batterie formée de plusieurs cellules et embarquée à bord d'un véhicule terrestre à moteur, le procédé comprenant les étapes de :
- recevoir des données de traitement générées par un calculateur du véhicule et transmises au moyen d'un appareil de communication par signaux radiofréquences agencé dans le véhicule, lesdites données de traitement incluant des données caractérisant un état de charge de la batterie, des données caractérisant au moins une mesure de tension pour chacune des cellules, des données caractérisant au moins une mesure d'intensité pour chacune des cellules, des données caractérisant au moins une mesure de température pour chacune des cellules et des données caractérisant un trajet effectué par le véhicule,
- déterminer, pour chacune des cellules, une valeur d'un paramètre caractérisant l'état de santé de la cellule en utilisant les données caractérisant au moins une mesure de tension pour chacune des cellules, les données caractérisant au moins une mesure d'intensité pour chacune des cellules et les données caractérisant au moins une mesure de température pour chacune des cellules,
- déterminer au moins une valeur d'un paramètre caractérisant une utilisation de la batterie en utilisant les données caractérisant un état de charge de la batterie et les données caractérisant un trajet effectué par le véhicule, et
- déterminer la valeur du paramètre caractérisant l'état de santé de la batterie en utilisant les valeurs des paramètres caractérisant l'état de santé de chacune des cellules et la valeur caractérisant une utilisation de la batterie.

Selon une variante, les données caractérisant un trajet effectué par le véhicule peuvent inclure des données caractérisant au moins une valeur de consommation induite par ledit trajet.

Selon une autre variante, les données caractérisant un trajet effectué par le véhicule peuvent inclure des données caractérisant au moins une valeur de charge emmagasinée lors d'une phase de décélération et/ou d'un freinage intervenu(e) pendant ledit trajet.

Selon une autre variante, les données caractérisant un trajet effectué par le véhicule peuvent être générées en utilisant un appareillage de géolocalisation du véhicule.

L'invention a en outre pour objet un système informatique de détermination d'une valeur d'un paramètre caractérisant l'état de santé d'une batterie formée de plusieurs cellules et embarquée à bord d'un véhicule terrestre à moteur, le système comprenant des moyens mettant en oeuvre un procédé tel que défini ci-dessus.

Selon une variante, le système peut comprendre au moins un processeur et un support de stockage de données dans lesquels est stocké au moins un programme pour l'exécution d'étapes selon le procédé mis en oeuvre par le système.

L'invention a en outre pour objet un programme d'ordinateur comprenant des instructions pour l'exécution des étapes d'un procédé tel que défini ci-dessus.

L'invention a en outre pour objet un support utilisable dans un ordinateur sur lequel est enregistré un programme tel que défini ci-dessus.

L'invention est définie par le procédé de la revendication 1, le système informatique de la revendication 5, le programme d'ordinateur de la revendication 7 et le support de la revendication 8.

### Brève description des figures

D'autres caractéristiques et avantages de l'invention apparaîtront à l'examen de la description détaillée ci-après, et des dessins annexés, sur lesquels :
[Fig. 1] est un schéma fonctionnel d'un système selon l'invention, et
[Fig. 2] est un organigramme illustrant certaines étapes du procédé selon l'invention.

### Description détaillée de l'invention

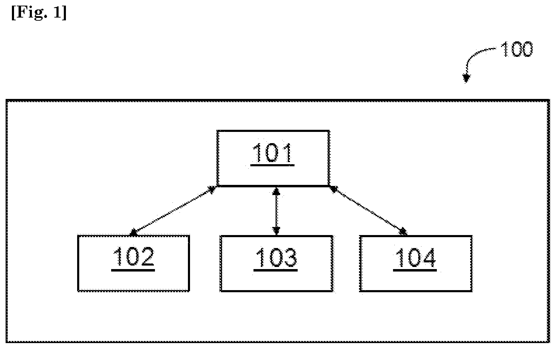

Le système informatique de détermination 100 d'une valeur d'un paramètre caractérisant l'état de santé d'une batterie formée de plusieurs cellules et embarquée à bord d'un véhicule terrestre à moteur selon la présente invention est illustré sur la figure 1. Le système informatique de détermination 100 comprend une unité de traitement d'informations 101, comprenant un ou plusieurs processeurs, un support de stockage de données 102, au moins une interface d'entrée et sortie 103. En outre, le système informatique de détermination 100 comprend une interface 104 avec un réseau de communication, privé ou public, par exemple Internet, afin d'envoyer et recevoir des données. Selon certains modes de réalisation de l'invention, le système informatique de détermination 100 comprend un ou plusieurs ordinateurs, un ou plusieurs serveurs, un ou plusieurs supercalculateurs et/ou n'importe quelle combinaison comprenant l'un de ces systèmes informatiques.

Selon l'invention, tous les éléments décrits ci-dessus contribuent pour permettre au système 100 de mettre en oeuvre le procédé de détermination d'une valeur d'un paramètre caractérisant l'état de santé d'une batterie formée de plusieurs cellules et embarquée à bord d'un véhicule terrestre à moteur tel que décrit ci-dessous.

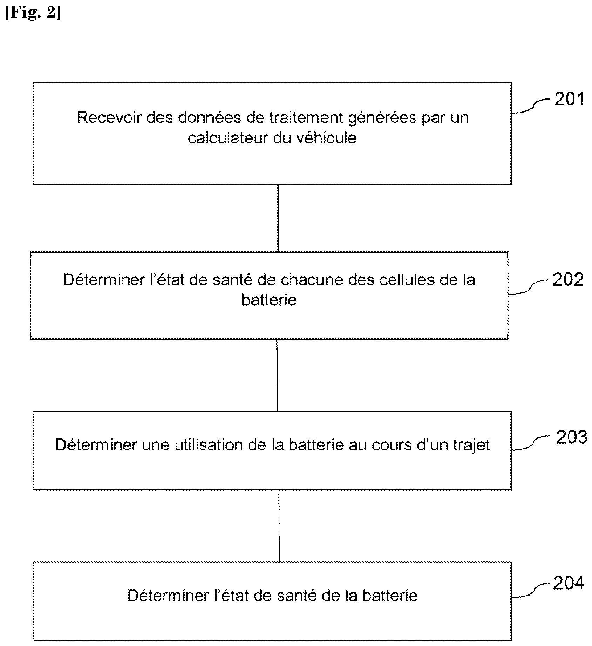

Comme illustré à la figure 2, selon une étape 201, le système informatique de détermination 100 reçoit des données de traitement générées par un calculateur du véhicule et transmises au moyen d'un appareil de communication par signaux radiofréquences agencé dans le véhicule. De manière avantageuse, ces données de traitement incluent des données caractérisant un état de charge de la batterie, des données caractérisant au moins une mesure de tension pour chacune des cellules, des données caractérisant au moins une mesure d'intensité pour chacune des cellules, des données caractérisant au moins une mesure de température pour chacune des cellules et des données caractérisant un trajet effectué par le véhicule. De préférence, les données caractérisant un état de charge de la batterie, les données caractérisant au moins une mesure de tension pour chacune des cellules, les données caractérisant au moins une mesure d'intensité pour chacune des cellules et des données caractérisant au moins une mesure de température pour chacune des cellules sont générées par le calculateur du véhicule sur la base de signaux électriques émis par des capteurs agencés dans le véhicule et aptes à effectuer des mesures de tension, d'intensité et de température pour chacune des cellules de la batterie du véhicule. D'autre part, les données caractérisant un trajet effectué par le véhicule sont générées par le calculateur en interagissant avec un appareillage de géolocalisation agencé dans le véhicule, comprenant un récepteur interagissant avec un système de positionnement par satellites. De manière avantageuse, en plus de données caractérisant des coordonnées géographiques en lien avec le trajet, les données caractérisant un trajet effectué par le véhicule incluent des données caractérisant au moins une valeur de consommation induite par ledit trajet. Alternativement, ou cumulativement, les données caractérisant un trajet effectué par le véhicule incluent des données caractérisant au moins une valeur de charge emmagasinée lors d'une phase de décélération et/ou d'un freinage qui est intervenu(e) pendant le trajet.

Ensuite, selon une autre étape 202, en utilisant au moins l'unité de traitement d'informations 101 et le support de stockage de données 102, le système informatique de détermination 100 détermine, pour chacune des cellules, une valeur d'un paramètre caractérisant l'état de santé de la cellule. Pour ce faire, le système informatique de détermination 100 utilise les données caractérisant au moins une mesure de tension pour chacune des cellules, les données caractérisant au moins une mesure d'intensité pour chacune des cellules et les données caractérisant au moins une mesure de température pour chacune des cellules.

Ensuite, selon une autre étape 203, en utilisant au moins l'unité de traitement d'informations 101 et le support de stockage de données 102, le système informatique de détermination 100 détermine au moins une valeur d'un paramètre caractérisant une utilisation de la batterie pendant le trajet effectué par le véhicule. Pour ce faire, le système informatique de détermination 100 utilise les données caractérisant un état de charge de la batterie et les données caractérisant un trajet effectué par le véhicule, notamment les données caractérisant au moins une valeur de consommation induite par ledit trajet et les données caractérisant au moins une valeur de charge emmagasinée lors d'une phase de décélération et/ou d'un freinage intervenu(e) pendant le trajet.

Enfin, selon une ultime étape 204, en utilisant au moins l'unité de traitement d'informations 101 et le support de stockage de données 102, le système informatique de détermination 100 détermine la valeur du paramètre caractérisant l'état de santé de la batterie en utilisant les valeurs des paramètres caractérisant l'état de santé de chacune des cellules et la valeur caractérisant une utilisation de la batterie.

Par conséquent, aux termes du procédé et du système selon l'invention décrits ci-dessus, des briques fonctionnelles sont fournies pour permettre de contrôler le bon fonctionnement d'une batterie embarquée à bord d'un véhicule terrestre à moteur sans nécessiter l'immobilisation du véhicule. De plus, par le choix spécifique de paramètres de traitement exposé ci-dessus, le procédé et le système selon l'invention permettent de déterminer avec une plus grande précision l'état de santé d'une batterie embarquée à bord d'un véhicule terrestre à moteur.

L'invention ne se limite pas aux modes de réalisation décrits ci-dessus, présentés uniquement à titre d'exemples.

## Revendications

1. Procédé de détermination par un système informatique (100) d'une valeur d'un paramètre caractérisant l'état de santé d'une batterie formée de plusieurs cellules et embarquée à bord d'un véhicule terrestre à moteur, le procédé comprenant les étapes de :
- recevoir des données de traitement générées par un calculateur du véhicule et transmises au moyen d'un appareil de communication par signaux radiofréquences agencé dans le véhicule, lesdites données de traitement incluant des données caractérisant un état de charge de la batterie, des données caractérisant au moins une mesure de tension pour chacune des cellules, des données caractérisant au moins une mesure d'intensité pour chacune des cellules, des données caractérisant au moins une mesure de température pour chacune des cellules et des données caractérisant un trajet effectué par le véhicule,
- déterminer, pour chacune des cellules, une valeur d'un paramètre caractérisant l'état de santé de la cellule en utilisant les données caractérisant au moins une mesure de tension pour chacune des cellules, les données caractérisant au moins une mesure d'intensité pour chacune des cellules et les données caractérisant au moins une mesure de température pour chacune des cellules,
- déterminer au moins une valeur d'un paramètre caractérisant une utilisation de la batterie en utilisant les données caractérisant un état de charge de la batterie et les données caractérisant un trajet effectué par le véhicule, et
- déterminer la valeur du paramètre caractérisant l'état de santé de la batterie en utilisant les valeurs des paramètres caractérisant l'état de santé de chacune des cellules et la valeur caractérisant une utilisation de la batterie.

2. Procédé selon la revendication 1, **caractérisé en ce que** les données caractérisant un trajet effectué par le véhicule incluent des données caractérisant au moins une valeur de consommation induite par ledit trajet.

3. Procédé selon l'une des revendications précédentes, **caractérisé en ce que** les données caractérisant un trajet effectué par le véhicule incluent des données caractérisant au moins une valeur de charge emmagasinée lors d'une phase de décélération et/ou d'un freinage intervenue/ intervenu pendant ledit trajet.

4. Procédé selon l'une des revendications précédentes, **caractérisé en ce que** les données caractérisant un trajet effectué par le véhicule sont générées en utilisant un appareillage de géolocalisation du véhicule.

5. Système informatique (100) de détermination d'une valeur d'un paramètre caractérisant l'état de santé d'une batterie formée de plusieurs cellules et embarquée à bord d'un véhicule terrestre à moteur, le système comprenant des moyens (101, 102, 103, 104) mettant en oeuvre un procédé selon l'une quelconque des revendications précédentes.

6. Système selon la revendication 5, **caractérisé en ce qu'**il comprend au moins un processeur (101) et un support de stockage de données (102) dans lesquels est stocké au moins un programme pour l'exécution d'étapes selon le procédé mis en oeuvre par le système.

7. Programme d'ordinateur comprenant des instructions de code de programme pour l'exécution des étapes d'un procédé selon l'une quelconque des revendications 1 à 4 lorsque ledit programme est exécuté sur un ordinateur.

8. Support utilisable dans un ordinateur et sur lequel est enregistré un programme selon la revendication 7.

## Patentansprüche

1. Verfahren zur Bestimmung eines Wertes eines Parameters, der den Gesundheitszustand einer aus mehreren Zellen gebildeten und an Bord eines motorisierten Landfahrzeugs mitgeführten Batterie charakterisiert, durch ein Computersystem (100), wobei das Verfahren die folgenden Schritte umfasst: :
- Empfangen von Verarbeitungsdaten, die von einem Rechner des Fahrzeugs erzeugt und mittels eines im Fahrzeug angeordneten Kommunikationsgeräts für Hochfrequenzsignale übertragen werden, wobei die Verarbeitungsdaten Daten enthalten, die einen Ladezustand der Batterie charakterisieren, Daten, die mindestens eine Spannungsmessung für jede der Zellen charakterisieren, Daten, die mindestens eine Intensitätsmessung für jede der Zellen charakterisieren, Daten, die mindestens eine Temperaturmessung für jede der Zellen charakterisieren, und Daten, die eine von dem Fahrzeug zurückgelegte Strecke charakterisieren,
- für jede der Zellen einen Wert eines Parameters zu bestimmen, der den Gesundheitszustand der Zelle charakterisiert, indem die Daten, die mindestens eine Spannungsmessung für jede der Zellen charakterisieren, die Daten, die mindestens eine Intensitätsmessung für jede der Zellen charakterisieren, und die Daten, die mindestens eine Temperaturmessung für jede der Zellen charakterisieren, verwendet werden,
- Bestimmen mindestens eines Werts eines Parameters, der eine Nutzung der Batterie charakterisiert, unter Verwendung der Daten, die einen Ladezustand der Batterie charakterisieren, und der Daten, die eine vom Fahrzeug zurückgelegte Strecke charakterisieren, und
- Bestimmen des Werts des Parameters, der den Gesundheitszustand der Batterie charakterisiert, unter Verwendung der Werte der Parameter, die den Gesundheitszustand jeder der Zellen charakterisieren, und des Werts, der eine Nutzung der Batterie charakterisiert.

2. Verfahren nach Anspruch 1, **dadurch gekennzeichnet, dass** die Daten, die eine vom Fahrzeug zurückgelegte Strecke charakterisieren, Daten einschließen, die mindestens einen durch die Strecke induzierten Verbrauchswert charakterisieren.

3. Verfahren nach einem der vorhergehenden Ansprüche, **dadurch gekennzeichnet, dass** die Daten, die eine vom Fahrzeug durchgeführte Fahrt charakterisieren, Daten umfassen, die mindestens einen Wert der Ladung charakterisieren, die während einer Verzögerungsphase und/oder einer Bremsung gespeichert wird, die während der Fahrt stattgefunden hat/stattgefunden hat.

4. Verfahren nach einem der vorhergehenden Ansprüche, **dadurch gekennzeichnet, dass** die Daten, die eine vom Fahrzeug zurückgelegte Strecke charakterisieren, unter Verwendung einer Vorrichtung zur Geolokalisierung des Fahrzeugs generiert werden.

5. Computersystem (100) zur Bestimmung eines Wertes eines Parameters, der den Gesundheitszustand einer Batterie charakterisiert, die aus mehreren Zellen besteht und an Bord eines motorisierten Landfahrzeugs mitgeführt wird, wobei das System Mittel (101, 102, 103, 104) umfasst, die ein Verfahren nach einem der vorhergehenden Ansprüche durchführen.

6. System nach Anspruch 5, **dadurch gekennzeichnet, dass** es mindestens einen Prozessor (101) und ein Datenspeichermedium (102) umfasst, in denen mindestens ein Programm zur Ausführung von Schritten gemäß dem durch das System implementierten Verfahren gespeichert ist.

7. Computerprogramm mit Programmcodeanweisungen zur Ausführung von Schritten eines Verfahrens nach einem der Ansprüche 1 bis 4, wenn das Programm auf einem Computer ausgeführt wird.

8. Medium, das in einem Computer verwendet werden kann und auf dem ein Programm nach Anspruch 7 gespeichert ist.

## Claims

1. A method of determining by a computer system (100) a value of a parameter characterising the state of health of a battery formed of a plurality of cells and carried on board a land motor vehicle, the method comprising the steps of :
- receiving processing data generated by a computer of the vehicle and transmitted by means of a radio-frequency signal communication apparatus arranged in the vehicle, said processing data including data characterising a state of charge of the battery, data characterising at least one voltage measurement for each of the cells, data characterising at least one current measurement for each of the cells, data characterising at least one temperature measurement for each of the cells and data characterising a journey made by the vehicle
- determining, for each of the cells, a value of a parameter characterising the state of health of the cell using the data characterising at least one voltage measurement for each of the cells, the data characterising at least one current measurement for each of the cells and the data characterising at least one temperature measurement for each of the cells,
- determining at least one value of a parameter characterising a use of the battery using the data characterising a state of charge of the battery and the data characterising a journey made by the vehicle, and
- determining the value of the parameter characterising the state of health of the battery using the values of the parameters characterising the state of health of each of the cells and the value characterising a use of the battery.

2. The method according to claim 1, **characterized in that** the data characterizing a journey made by the vehicle includes data characterizing at least one consumption value induced by said journey.

3. A method according to any of the preceding claims, **characterised in that** the data characterising a journey made by the vehicle includes data characterising at least one value of charge stored during a deceleration phase and/or braking that occurred during said journey.

4. A method according to any of the preceding claims, **characterised in that** the data characterising a journey made by the vehicle is generated using a vehicle geolocation apparatus.

5. Computer system (100) for determining a value of a parameter characterising the state of health of a battery formed of several cells and carried on board a land motor vehicle, the system comprising means (101, 102, 103, 104) implementing a method according to any of the preceding claims.

6. A system according to claim 5, **characterised in that** it comprises at least one processor (101) and a data storage medium (102) in which is stored at least one program for the execution of steps according to the method implemented by the system.

7. A computer program comprising program code instructions for the execution of steps of a method according to any of claims 1 to 4 when said program is executed on a computer.

8. A medium usable in a computer and having recorded thereon a program according to claim 7.
